# EUROPEAN PATENT APPLICATION

(11) **EP 2 323 253 A1**
(43) Date of publication of application: **18.05.2011**
(21) Application number: 09290819.3
(22) Date of filing: 26.10.2009
(51) Int. Cl.: H03F 1/02

(54) **Doherty power amplifiers**

(71) Applicant: Alcatel Lucent, 75008 Paris (FR)
(72) Inventor: Wong, James, Swindon, Wiltshire SN5 7YT (GB); Jones, Bob, Swindon, Wiltshire SN5 7YT (GB); Roff, Chris, Swindon, Wiltshire SN5 7YT (GB); Finnell, John, Swindon, Wiltshire SN5 7YT (GB)
(74) Representative: Knights, Rupert

(57) **Abstract**

A Doherty amplifier is disclosed, comprising at least first and second devices under test (DUTs) which differ from one another, and means for altering the input and/or output loads and/or phase to optimise output characteristics.

## Description

### Field of the Invention

This invention relates to Doherty power amplifiers. In particular, it relates to optimised power amplifiers which have greater flexibility in use than previous designs.

### Background

Doherty amplifiers have recently come to prominence again for use as power amplifiers in the telecommunications field, to provide power amplification of RF signals. In a classic Doherty arrangement, an RF input signal is split evenly to drive two amplifiers and a combining network sums the two output signals and corrects for phase differences between the two amplifiers. The amplifiers or other devices (known as Devices Under Test - DUTs) are generally the same type of device from the same manufacturer.

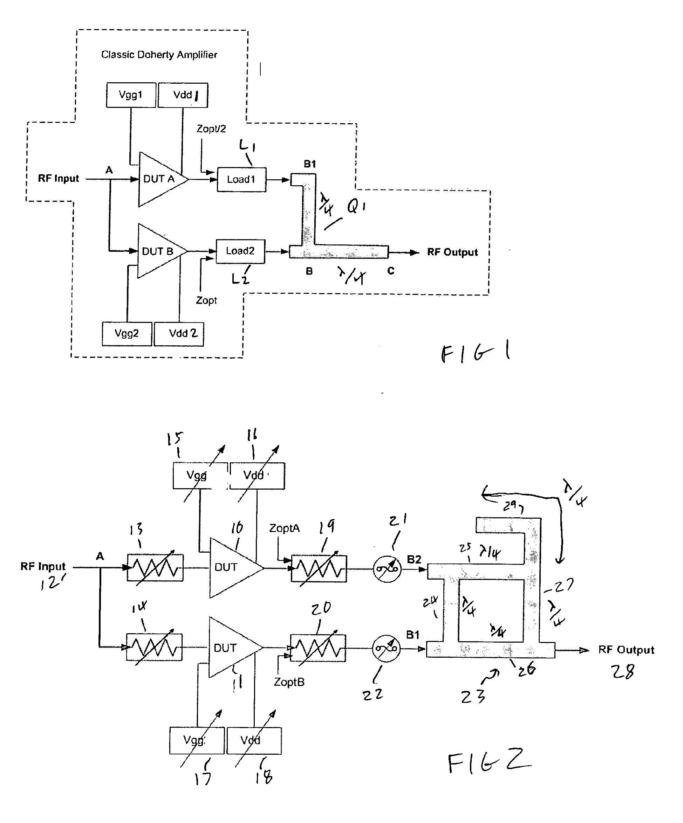

Figure 1 shows a typical prior art Doherty configuration. An RF input 1 is applied equally to two DUTs; DUTA and DUTB from the same manufacturer. Each of these are fed with appropriate (fixed) gain voltages (Vgg1 and Vgg2) and drain voltages (Vdd1 and Vdd2) respectively. The outputs from the respective devices DUTA and DUTB are applied to respective loads, L1 and L2, which have impedances Zopt1 and Zopt2 which are of a fixed value for the fixed bias conditions (drain and grain voltages). Outputs from the loads are applied to a quarter wave network which operates in known manner and has a quarter wavelength (λ/4) length of transmission line between an input B from load 2 and an input B1 from load 1, and a quarter wavelength line between input B and an output C, to provide an RF output.

Such amplifiers are well-known. However, they can be inflexible and cannot be easily adjusted for variations in output power. In addition, they require the DUTs to be the same device from the same manufacturer. This can be wasteful of power and sometimes unnecessarily expensive. The dynamic range is also limited.

The present invention arose in an attempt to provide an improved Doherty amplifier.

### Summary

According to the present invention there is provided a Doherty amplifier comprising at least first and second devices under test (DUTs) which differ from one another, and means for altering the input and/or output loads and/or phase to optimise output characteristics.

The device may be from the same or different manufacturer and/or of different technologies. For example, they may be chosen from Laterally Diffused Metal Oxide Semi-conductor Field Effect Transistors (LDMOS FET), Gallium Nitride Field Effect Transistors (GaN FET), Gallium Arsenide Field Effect Transistors (GaAs FET), Heterojunction Bipolar Transistors or other devices. One of the devices may be of one type and the other one of another type, and there may be different types made by different manufacturers, or the same type and made by different manufacturers. They may be of different characteristics.

The apparatus may comprise respective variable output loads connected to the output of the DUTs.

The apparatus may further comprise respective variable input loads connected to the input of each DUT whereby the proportion of a respective RF input signal which is provided to each DUT can be varied.

The apparatus may comprise respective variable phase adjusters for adjusting the phase of the output from each DUT before it enters a quarter wave impedance network.

The apparatus may include means for providing variable gain voltage and/or drain voltage to each respective DUT.

In accordance with the invention in a second aspect, there is provided a method of obtaining an optimised Doherty amplifier, comprising providing at least two non-identical Devices Under Test (DUTs), and adjusting the input and/or output load and/or phase associated with each device so as to optimise load impedance and/or phase.

### Brief Description of the Drawings

Embodiments of the invention will now be described, by way of example only, with reference to the accompanying drawings, in which:
Figure 1 shows a prior art Doherty amplifier;
Figure 2 shows an amplifier in accordance with an embodiment of the present invention; and
Figure 3 shows Power Diagrams.

### Description of Embodiments

Referring to Figure 2, a Doherty amplifier circuit is shown.

This circuit comprises two devices under test (DUT) 10 and 11 which are different devices. By this is meant that they may be the same type of device but by different manufacturers or devices using different technology, whether provided by the same manufacturer or not, or devices having different characteristics. Examples of technologies are LDMOS FETs, GaN FETs, GaAs FETs, Heterojunction bipolar transistor devices, or other devices. In one non-limiting example, DUT 10 is a 100 W LDMOS device manufactured by NXP and DUT 11 is a 160 W GaN device manufactured by Sumitomo.

An RF input 12 (eg in the GH_{z} region) at node A is applied to respective load impedances 13 and 14. Impedance 13 is associated with DUT 10 and 14 is associated with DUT 11. These are variable devices and thus the total RF input applied at 12 can be applied in variable proportions to the two DUTs, in contrast to the system of Figure 1 where it is equally applied.

Independent variable sources of gain voltage and drain voltage are also connected to each respective DUT. Thus, DUT 10 is supplied with variable gain voltage from variable voltage source 50 and variable drain voltage from voltage source 60 and DUT 11 is provided with variable gain voltage from variable voltage source 17 and variable drain voltage from variable voltage source 18.

The outputs from each respective DUT 10 and 11 are applied to respective variable loads 19 and 20. These may termed impedance matching networks. These are used to optimise the load impedance of each respective device and thus they may of course be tuned to different impedance values. Thus, load 19 may be tuned to impedance ZoptA and the impedance device 20 may be tuned to impedance ZoptB, which will generally be different to ZoptA.

The outputs from the respective output loads 19 and 20 are applied through phase shifters/phase adjusters 21 and 22 which are set such that the signal applied to an output quarter wave network 23 satisfies the relationship that the signal at B2 (from DUT 10) is approximately 90° to the signal from B1 (DUT 11). It may alternatively be arranged to have a different phase difference.

The quarter wave network 23 includes a quarter wavelength section 25 between outputs B1 (from DUT 11) and B2 (from DUT 10). Respective components 25 and 26 from B2 and B 1 respectively are quarter wave lines and the distal ends of these are connected by a further quarter wave line 27 to an RF output 28. A stub 29 is open ended, which makes this into a short circuit.

DUTA generally will not be equal to DUTB. Typical values of drain and gate voltage for the type of devices used in one embodiment (DUT 10 is a 100 W LT MOSS device manufactured by NXP and DUT 11 is a 160 W GaN device manufactured by Sumitomo) are, DUT 10; Vdd = 28 V and Vgg = plus 2 V, and, DUT 11; Vdd = 50 V and Vgg = - 3.5 V.

A setting up process in some embodiments is as follows, although the order in which the tuning is done may differ.

Firstly, the output impedance of DUT 10 is tuned to ZoptA. Then, the output impedance 20 of DUT 11 is tuned to ZoptB. Note that ZoptA will in general not be equal to ZoptB and will also not in general be equal ½ ZoptB.

Note that with prior art Doherty transformers, the output from one DUT will generally be half that of the other. Referring briefly to Figure 1, the impedance at load L1 will generally be half that of the impedance at load L2. This arises through known characteristics of such devices and will be apparent to the skilled reader.

Referring back to the apparatus of Figure 2, the input impedances of respective DUTs 10 and 11 are then using input loads 13 and 14 tuned. Again, these will be different as described. Typically, the input for DUT 10 will be tuned such that the input return loss is greater than 15 dB.

Finally, the respective phases of the outputs from the two DUTs can be adjusted (using phase adjusters 21 and 22) such that the phase at B2 is approximately 90° to that at B1. Phase adjusters in themselves are well-known.

By using techniques in accordance with the present invention, the power output, mean value and maximum power, can be varied and different devices from different manufacturers, using different technologies can be used in Doherty amplifiers, which can have considerable benefits. In addition, power savings can be achieved by being able to use lower power DUTs. For example, in a classic Doherty construction, if 200 W of output power is required, then the two DUTs will be required to each be of 100 W. With the present invention, one of the DUTs may be of 80 W and the other of 120 W and it could be considerably easier to manufacturer and/or cheaper to buy an 80 W device than a 100 W device, which can lead to cost savings.

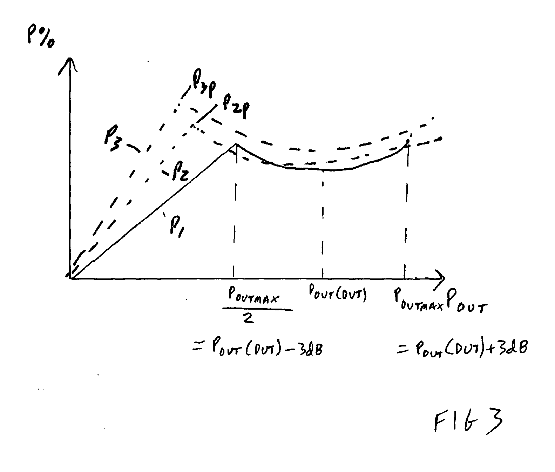

Figure 3 shows schematically a diagram of efficiency against output power (not to scale) for different versions of Doherty amplifiers. The solid line P1 represents a typical prior art Doherty amplifier in which DUTA = DUTB (see Figure 1). Thus, load 1 = ½ of load 2 so the power output Pout = ½ Pout MAX. Thus, the power output from one DUT is Pout + 3dB and the power output from the other DUT is Pout - 3dB.

The first dashed line P2 shows the equivalent for one embodiment using a specific optimising and shows how the value of Pout (DUT) might vary. This could lead to improved performance at power levels that are the averaged of higher peak-to-average signals. For example, a WCDMA signal with a 6.5dB PAR will have more efficiency benefits using a symmetrical Doherty compared to a WiMAX signal with a 8dB PAR in the same configuration.] By using other values of load and/or phase tuning this may vary and P3 shows another tuning example. Thus, with embodiments of the invention, more use can be made of the output power of the DUT.

## Claims

1. A Doherty amplifier comprising at least first and second devices under test (DUTs) which differ from one another, and means for altering the input and/or output loads and/or phase to optimise output characteristics.

2. An amplifier as claimed in Claim 1, wherein the devices are from the same or different manufacturers and/or of different technologies.

3. An amplifier as claimed in Claim 1 or Claim 2, wherein the devices are chosen from Laterally Diffused Metal Oxide Semi-conductor Field Effect Transistors (LDMOSFET), Gallium Nitride Field Effect Transistors (GaNFET), Gallium Arsenide Field Effect Transistors (GAFET), Heterojunction Bipolar Transistors.

4. Apparatus as claimed in any preceding claim, comprising respective variable output loads connected to the output of each DUT.

5. Apparatus as claimed in any preceding claim, comprising respective variable input loads, each arranged to receive an RF input and to provide an output to the input of a respective DUT.

6. Apparatus as claimed in claim 5 wherein the input loads receive inputs form a common RF source.

7. Apparatus as claimed in any preceding claim, comprising a respective variable phase adjuster adapted to adjust the phase of the output from each respective DUT.

8. Apparatus as claimed in Claim 7, wherein the phase tuners are adapted such that the phase of a signal output from a first DUT is about 90° different from that from a second DUT.

9. Apparatus as claimed in any preceding claim, including a quarter wave impedance network.

10. Apparatus as claimed in any preceding claim, comprising a variable gain voltage source for providing a variable gain voltage to each respective DUT.

11. Apparatus as claimed in any preceding claim, comprising respective drain voltage sources for providing a variable drain voltage to each respective DUT.

12. A method of obtaining an optimised Doherty amplifier comprising providing at least two non-identical devices under test (DUT) and adjusting the input and/or output load and/or output phase associated with each device so as to optimise load impedance and/or phase.

13. A method as claimed in Claim 12, including adjusting the respective output load of the devices under test.

14. A method as claimed in Claim 12 or 13, comprising adjusting the proportion of an input signal which is provided to each respective DUT via variable input loads.

15. A method as claimed in any of Claims 12 to 14, including adjusting the phase output from each respective DUT such that the phase from one DUT is approximately 90° different to that of a second DUT.
